# EUROPÄISCHE PATENTSCHRIFT

(11) **EP 1 744 363 B1**
(45) Veröffentlichungstag und Bekanntmachung des Hinweises auf die Patenterteilung: **26.03.2008**
(21) Anmeldenummer: 06014307.0
(22) Anmeldetag: 11.07.2006
(51) Int. Cl.: H01L 23/66

(54) **Monolithisch integrierte Schaltung mit integrierter Entstörvorrichtung**
Monolithic integrated circuit with integrated noise reduction
Circuit intégré monolithique avec réduction de bruit intégré

(30) Priorität: 16.07.2005 DE 102005033306
(43) Veröffentlichungstag der Anmeldung: 17.01.2007
(73) Patentinhaber: ATMEL Germany GmbH, 74072 Heilbronn (DE)
(72) Erfinder: Fischer, Harald, 56338 Brauchbach-Rhein (DE)

(56) Entgegenhaltungen:
- EP-A- 1 251 561
- US-A1- 2004 036 165
- US-B1- 6 369 678

## Beschreibung

Die Erfindung betrifft eine monolithisch integrierte Schaltung mit mindestens einem ein Signal führenden Signalanschluss und mit einer in die Schaltung integrierten Entstörvorrichtung zur Verringerung von Störstrahlung.

Schaltungen dieser Art sind per se bekannt und basieren im Wesentlichen auf einer Abschirmung von vor Störstrahlung zu schützenden Elementen mittels elektrischer Leiter, die möglichst großflächig um die betreffenden Elemente anzuordnen und mit einem Bezugspotential, insbesondere einem Massepotential der Schaltung, zu verbinden sind.

Ein Beispiel für eine derartige herkömmliche Schaltung ist in der US 6,307,252 B1 angegeben. Dort wird ein vor Störstrahlung zu schützender Signalleiter auf drei Seiten von zur Abschirmung dienenden Leitern umgeben, die untereinander elektrisch leitend verbunden sind.

Die beschriebene Anordnung sowie weitere herkömmliche Schaltungen, welche nach dem Faraday-Prinzip abgeschirmt werden, haben den Nachteil, dass einerseits eine verhältnismäßig große Metallfläche innerhalb der integrierten Schaltung zur Ausbildung von abschirmenden Leitern verwendet wird und dass andererseits keine gezielte Verringerung von Störstrahlung und/oder leitungsgebundenen Störungen bestimmter Frequenzen möglich ist.

Eine andere Aufbauweise mit einer diskret ausgebildeten Entstörvorrichtung beschreibt die US 2004/0036165 A1, bei der ein Transceiver-Modul mit einer Leiterplatte und einem Chipsatz mit monolithischen, integrierten Mikrowellen-Transceiver-Chips (MMIC) vorgesehen ist. Der Chipsatz ist auf einer Oberfläche der Leiterplatte angebracht und weist mehrere MMIC-Baugruppen auf. Die MMIC-Baugruppen bestehen jeweils aus einer mehrlagig ausgeführten Dickschichtkeramik (low temperature transfer tape LTTC) mit mehreren Ausschnitten, in die MMIC-Chips eingebracht sind, die aus Gallium-Arsenid (GaAs) hergestellt sein können und die über Bonddrähte mit der Dickschichtkeramik elektrisch verbunden sind. Auf einer obersten Lage der Dickschichtkeramik ist ein Filter verwirklicht, der elektrisch mit zumindest einem der MMIC-Chips verbunden ist.

Im IEEE MTT-S Digest (Jahrgang 2003, Seiten 543 - 546) werden unter der Überschrift "New Parallel λ/2-Microstrip Line Filters With Transmission Zeros at Finite Frequencies" aus parallelen Streifenleitern aufgebaute Filter mit Transmissions-Nullstellen vorgestellt, deren Filterwirkung auf internen Anti-Reflektionen basiert.

Demgemäß ist es Aufgabe der vorliegenden Erfindung, eine monolithisch integrierte Schaltung der eingangs genannten Art derart zu verbessern, dass eine Verringerung von Störstrahlung bzw. leitungsgebundenen Störungen in einem vorgebbaren Frequenzbereich möglich ist und gleichzeitig eine im Vergleich zu herkömmlichen Schaltungen verhältnismäßig geringe Metallfläche in der integrierten Schaltung verwendet wird.

Diese Aufgabe wird bei der Schaltung der eingangs genannten Art erfindungsgemäß dadurch gelöst, dass die Entstörvorrichtung mindestens eine Streifenleitung mit einem Abschnitt aufweist, dessen Anfang mit dem Signalanschluss gekoppelt ist, und dessen Ende kurzgeschlossen ist, wobei eine Länge des Abschnitts in Abhängigkeit einer vorgebbaren Frequenz, insbesondere in Abhängigkeit einer zu unterdrückenden Frequenz der Störstrahlung, gewählt ist. Bevorzugt wird die Länge des Abschnitts der Streifenleitung so gewählt, dass sie einem ganzzahligen Vielfachen derjenigen halben Wellenlänge entspricht, die mit einer zu unterdrückenden Frequenz der Störstrahlung korrespondiert. Auf diese Weise wird der an dem Ende des Abschnitts angeordnete Kurzschluss durch die erfindungsgemäße Streifenleitung wieder in einen Kurzschluss an dem Anfang des Abschnitts der Streifenleitung transformiert, so dass bspw. von dem Signalanschluss in die Streifenleitung eingekoppelte Störsignale der entsprechenden Frequenz durch die erfindungsgemäße Streifenleitung an dem Anfang des Abschnitts kurzgeschlossen werden.

Durch die verhältnismäßig schmalbandige Wirkung des auf diese Weise durch die Durch die verhältnismäßig schmalbandige Wirkung des auf diese Weise durch die erfindungsgemäße Streifenleitung realisierten λ/2-Transformators ist eine gezielte Unterdrückung von Störstrahlung bzw. Störsignalen derjenigen Frequenz möglich, für die der λ/2-Transformator ausgelegt worden ist. Im Gegensatz zu einer externen, d.h. z.B. die Schaltung komplett umgebenden Abschirmung, ermöglicht die Erfindung eine Störunterdrückung direkt innerhalb der monolithisch integrierten Schaltung.

Eine derartige frequenzselektive Störunterdrückung ist insbesondere dann zweckmäßig, wenn die erfindungsgemäße Schaltung zum Einsatz in Systemen vorgesehen ist, bei denen Hochfrequenz-Störquellen bekannter Frequenz wie z.B. Oszillatoren oder dergleichen verwendet werden. Durch eine entsprechende Auslegung der erfindungsgemäßen Streifenleitung kann die Entstörvorrichtung so eingerichtet werden, dass eine maximale Unterdrückung einer bestimmten Frequenz der von der Hochfrequenz-Störquelle ausgehenden Störstrahlung möglich ist.

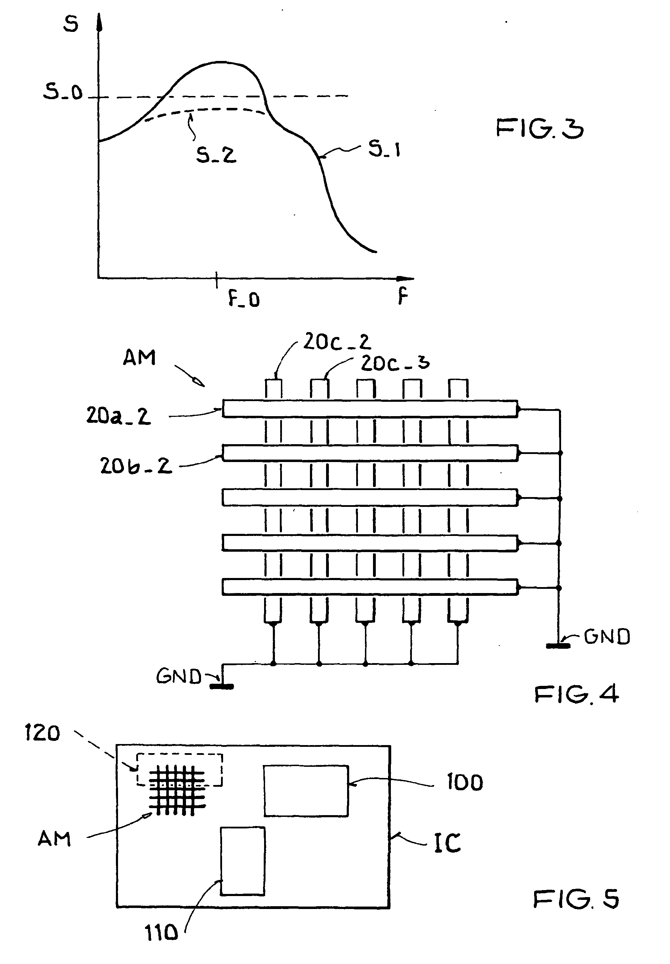

Bei einem bekannten Leistungsdichtespektrum der Störstrahlung, wie es zur Veranschaulichung in Figur 3 abgebildet ist, kann die Leistungsdichte auf die vorstehend beschriebene Weise über einen bestimmten Frequenzbereich gezielt beeinflusst werden, beispielsweise um bei vorgegebenen Frequenzen einzuhaltende Maximalwerte der Leistungsdichte nicht zu überschreiten.

Bei einer vorteilhaften Ausführungsform der vorliegenden Erfindung ist ein Wellenwiderstand der Streifenleitung so gewählt, dass an dem Anfang des Abschnitts für eine vorgebbare Frequenz Leistungsanpassung gegeben ist. Bei dieser Erfindungsvariante ist sichergestellt, dass eine maximale Störleistung in die erfindungsgemäße Streifenleitung eingekoppelt und damit von dem Signalanschluss abgeführt wird.

Bei einer weiteren, ganz besonders vorteilhaften Ausführungsform der vorliegenden Erfindung ist ein erster Leiter der Streifenleitung in einer ersten Metallisierungsebene der Schaltung angeordnet, und ein zweiter Leiter derselben Streifenleitung ist in einer zweiten Metallisierungsebene der Schaltung angeordnet. Bei dieser Konfiguration der erfindungsgemäßen Streifenleitung bildet eine zwischen den beiden Metallisierungsebenen angeordnete Isolierschicht, bei der es sich beispielsweise um eine Oxidschicht der Schaltung handelt, das u.a. den Wellenwiderstand der Streifenleitung beeinflussende Dielektrikum. Die effektive Dielektrizitätszahl der Streifenleitung kann über die Wahl der zwischen den Metallisierungsebenen befindlichen Isolierschicht oder auch durch die Geometrie der einzelnen Leiter der Streifenleitung beeinflusst werden. Ausgehend von einer vorgegebenen Geometrie der Leiter der Streifenleitung kann ein resultierender Wellenwiderstand der Streifenleitung beispielsweise mit einer der bekannten Näherungsformeln abgeschätzt werden. Aufgrund der Integration der Streifenleitung in die monolithisch integrierte Schaltung können sich jedoch je nach Realisierung der Schaltung z.B. abweichende Wellenwiderstände ergeben, weswegen eine numerische Simulation einer geplanten erfindungsgemäßen Entstörvorrichtung zweckmäßig ist.

Bei einer weiteren, besonders vielseitigen Ausführungsform der erfindungsgemäßen Entstörvorrichtung ist die Streifenleitung als Koplanarleitung ausgebildet, bei der alle Leiter der Streifenleitung in einer einzigen Metallisierungsebene der Schaltung angeordnet sind. Durch die Ausbildung der Streifenleitung als Koplanarleitung kann die erfindungsgemäße Entstörvorrichtung auch bei monolithisch integrierten Schaltungen vorgesehen werden, die nur eine einzige Metallisierungsebene aufweisen.

In vorteilhafter Weiterbildung der vorliegenden Erfindung ist es auch möglich, dass die Streifenleitung als eine drei Leiter umfassende Triplate-Leitung ausgebildet ist, bei der ein erster Masseleiter und ein zweiter Masseleiter der Triplate-Leitung jeweils in verschiedenen Metallisierungsebenen angeordnet ist. Ein Signalleiter der Triplate-Leitung ist zwischen den die Masseleiter aufnehmenden Metallisierungsebenen, vorzugsweise in einer weiteren Metallisierungsebene, angeordnet. Bei der Verwendung der vorstehend beschriebenen Triplate-Leitung ergibt sich eine besonders effektive Abschirmung des Signalleiters.

Eine andere vorteilhafte Ausführungsform der vorliegenden Erfindung sieht mehrere Streifenleitungen vor, die bspw. für einen einzigen Signalanschluss der Schaltung als jeweils bei unterschiedlichen Frequenzen bzw. Wellenlängen arbeitende λ/2-Transformatoren eingesetzt werden können. Mit einer derartigen Anordnung ist es möglich, gleichzeitig gezielt mehrere vorgebbare Frequenzen der Störstrahlung zu unterdrücken und somit eine breitbandigere Entstörung zu ermöglichen, verglichen mit dem Einsatz einer einzigen Streifenleitung.

Um die mehreren Streifenleitungen für verschiedene Frequenzen jeweils als λ/2-Transformator auszubilden sind die Längen der jeweiligen Streifenleitung entsprechend der zu unterdrückenden Frequenz bzw. Wellenlänge zu wählen. Ferner ist es, bspw. durch die Wahl von Isolierschichtbereichen mit unterschiedlicher Dielektrizitätszahl, möglich, verschiedene Streifenleitungen mit einem unterschiedlichen Wellenwiderstand zu versehen. Darüber hinaus kann der Wellenwiderstand jeder Streifenleitung individuell durch die entsprechende Wahl der Geometrie der jeweiligen Leiter eingestellt werden.

Erfindungsgemäß ist es auch möglich, eine einzige Streifenleitung derart vorzusehen, dass zwei verschiedene Abschnitte der Streifenleitung hinsichtlich ihrer Länge bis zu dem jeweiligen Ende oder hinsichtlich ihres Wellenwiderstands jeweils unterschiedlich konfiguriert sind, so dass auf diese Weise mit einer einzigen Streifenleitung insgesamt z.B. zwei λ/2-Transformatoren realisierbar sind, die jeweils für verschiedene Frequenzen ausgelegt sind. Bei dieser Konfiguration ist der Anfang beider Abschnitte jeweils in bekannter Weise mit dem Signalanschluss der Schaltung gekoppelt, während z.B. die Länge des ersten Abschnitts von der Länge des zweiten Abschnitts, der ebenfalls an seinem Ende kurzgeschlossen ist, verschieden ist. In diesem Fall stellt also jeder der beiden Abschnitte der Streifenleitung einen separaten λ/2-Transformator für die entsprechende Wellenlänge bzw. Frequenz dar.

Bei einer weiteren vorteilhaften Ausführungsform der vorliegenden Erfindung ist die Streifenleitung über Mittel zur kapazitiven Kopplung mit dem Signalanschluss verbunden. Durch die Hochpasscharakteristik einer kapazitiven Kopplung wird verhindert, dass ein niederfrequentes Nutzsignal von dem Signalanschluss der Schaltung in die Streifenleitung der Entstörvorrichtung einkoppelt, während jedoch hochfrequente Störsignale von dem Signalanschluss zu der Streifenleitung abgeführt werden können. Eine zur Realisierung der kapazitiven Kopplung verwendete Kapazität ist dementsprechend in Abhängigkeit der maximal an dem Signalanschluss auftretenden Frequenzen des Nutzsignals zu wählen.

Vorteilhaft können erfindungsgemäß auch mehrere Signalanschlüsse der Schaltung mit derselben Streifenleitung verbunden werden. Auf diese Weise kann eine Streifenleitung der Entstörvorrichtung gleichzeitig zur Entstörung von zwei oder mehr Signalanschlüssen der Schaltung dienen. Entsprechend den vorstehenden Ausführungen sind die jeweiligen Anschlusspunkte vorzugsweise so zu wählen, dass zumindest ein Abschnitt der Streifenleitung für jeweils einen Signalanschluss einen λ/2-Transformator darstellt.

Bei einer weiteren, ganz besonders vorteilhaften Ausführungsform der vorliegenden Erfindung sind die Masseleiter verschiedener Streifenleitungen nebeneinander, insbesondere parallel zueinander, und/oder orthogonal zueinander angeordnet und mit einem Massepotential der Schaltung verbunden, um eine Abschirmungsmatrix zu bilden. Bei dieser Ausführungsform der vorliegenden Erfindung wird die Tatsache ausgenutzt, dass bei dem Vorhandensein mehrerer Streifenleitungen ohnehin eine entsprechende Anzahl von Masseleitern vorhanden ist, die mit einem Massepotential der Schaltung verbunden sind. Diese Masseleiter können neben ihrer Funktion in der jeweiligen Streifenleitung gleichzeitig zusätzlich eine Abschirmfunktion gegen Störstrahlung übernehmen, die besonders wirksam ist, wenn mehrere der Masseleiter nebeneinander, parallel zueinander oder auch orthogonal zueinander angeordnet sind.

Durch eine derartige Abschirmungsmatrix aus den Masseleitern verschiedener Streifenleitungen ist neben der frequenzselektiven Störunterdrückung an den Signalanschlüssen gleichzeitig eine allgemeine elektrische Abschirmung realisiert, die nach dem Prinzip des Faradayschen Käfigs arbeitet.

Ganz besonders vorteilhaft deckt die Abschirmungsmatrix eine Komponente der Schaltung zumindest teilweise ab, um auf die Komponente einwirkende Störstrahlung und/oder von der Komponente ausgehende Störschaltung abzuschirmen. Auf diese Weise kann mittels der erfindungsgemäßen Abschirmungsmatrix auch eine Aussendung von Störstrahlung reduziert werden, die von in der Schaltung angeordneten Komponenten ausgeht. Bspw. können insbesondere Komponenten wie integrierte Oszillatoren oder Gleichspannungswandler mittels der Abschirmungsmatrix abgedeckt werden, um eine von der erfindungsgemäßen Schaltung ausgehende Störstrahlung zu vermindern.

Analog zu der Reduzierung von nach außen dringender Störstrahlung ist durch die erfindungsgemäße Abschirmungsmatrix auch ein Schutz der Schaltung bzw. von Komponenten der Schaltung vor Störstrahlung gegeben, die von außen auf die Schaltung eintrifft.

Generell ist die durch die Abschirmungsmatrix realisierte Abschirmwirkung breitbandiger als die Wirkung einer als λ/2-Transformator ausgebildeten Streifenleitung, weil alle diejenigen Frequenzen der Störstrahlung durch die erfindungsgemäße Abschirmungsmatrix abgeschirmt bzw. gedämpft werden, die unterhalb einer bestimmten Grenzfrequenz liegen, die von dem Abstand der Masseleiter der Streifenleitungen untereinander abhängt. Der jeweilige Abstand der Masseleiter untereinander ist dementsprechend vorzugsweise in Abhängigkeit mindestens einer Frequenz von zu unterdrückender bzw. abzuschirmender Störstrahlung zu wählen.

Zur Bildung der erfindungsgemäßen Abschirmungsmatrix können mehrere Masseleiter in derselben Metallisierungsebene der Schaltung angeordnet sein. Alternativ hierzu ist es auch möglich, mehrere, insbesondere auch parallel zueinander verlaufende Masseleiter, in verschiedenen Metallisierungsebenen der Schaltung vorzusehen, wobei diese untereinander mittels die verschiedenen Metallisierungsebenen verbindenden Kontaktierungen zu verbinden sind.

Ferner ist es möglich, eine erste Anzahl von Masseleitern in einer ersten Metallisierungsebene der Schaltung anzuordnen, und eine zweite Anzahl von Masseleitern, die beispielsweise jeweils orthogonal zu den Masseleitern der ersten Metallisierungsebene angeordnet sind, in einer zweiten Metallisierungsebene der Schaltung vorzusehen. Die zugehörigen Signalleiter der Streifenleitungen können jeweils in derselben oder auch einer anderen Metallisierungsebene der Schaltung angeordnet sein.

Aufgrund der guten Abschirmung des Signalleiters ist eine als Triplate-Leitung ausgeführte Streifenleitung besonders geeignet zum Aufbau der erfindungsgemäßen Abschirmungsmatrix.

Bei einer weiteren vorteilhaften Ausführungsform der vorliegenden Erfindung sind alle Leiter der Streifenleitung miteinander und/oder mit einem Massepotential verbunden. Insbesondere können bei dieser Ausführungsform die Leiter auch direkt im Bereich des Signalanschlusses miteinander verbunden sein, so dass der betreffende Signalanschluss über die Mittel zur kapazitiven Kopplung direkt mit einem Massepotential verbunden ist, wodurch alle eine durch die Kopplungskapazität definierte Grenzfrequenz übersteigenden Frequenzen von dem Signalanschluss direkt nach Masse abgeleitet werden.

Bei einer weiteren Ausführungsform der vorliegenden Erfindung ist der Signalanschluss ein Bondpad der Schaltung. Besonders zweckmäßig wird z.B. bei einer Ausbildung der Schaltung als Transceiver für einen Datenbus ein Bondpad mit der erfindungsgemäßen Entstörvorrichtung verbunden, das ein Kommunikationssignal für die Kommunikation auf dem Datenbus führt und das daher insbesondere leitungsgebundenen Störungen stärker ausgesetzt ist als andere Bondpads der Schaltung. Beispielsweise kann es sich bei der erfindungsgemäßen Schaltung um einen CAN (controller area network)-, LIN (local interconnect network)- oder einen Flexray-Transceiver handeln.

Insgesamt ist mittels der erfindungsgemäßen Entstörvorrichtung eine Reduktion von leitungsgebundenen Störungen, bspw. im Bereich eines Bondpads der Schaltung, möglich sowie eine verhältnismäßig breitbandige Abschirmung zumindest einzelner Komponenten der Schaltung vor Störstrahlung. Durch die Entstörvorrichtung wird sowohl eine Störeinstrahlung in die Schaltung als auch eine von der Schaltung ausgehende Störausstrahlung verringert.

Weitere Vorteile, Merkmale und Einzelheiten ergeben sich aus der nachfolgenden Beschreibung, in der unter Bezugnahme auf die Zeichnung verschiedene Ausführungsbeispiele der Erfindung dargestellt sind. Dabei können die in den Ansprüchen und in der Beschreibung erwähnten Merkmale jeweils einzeln für sich oder in beliebiger Kombination erfindungswesentlich sein.

In der Zeichnung zeigen:
- Figur 1: eine erste Ausführungsform der erfindungsgemäßen Entstörvorrichtung,
- Figur 2a: einen Querschnitt durch eine erste Ausführungsform einer monolithisch in die erfindungsgemäße Schaltung integrierten Streifenleitung,
- Figur 2b: einen Schichtaufbau eines Teils der erfindungsgemäßen Schaltung,
- Figur 2c: einen Querschnitt durch eine zweite Ausführungsform einer monolithisch in die erfindungsgemäße Schaltung integrierten Streifenleitung,
- Figur 2d: einen Querschnitt durch eine weitere Ausführungsform einer monolithisch in die erfindungsgemäße Schaltung integrierten Streifenleitung,
- Figur 3: ein Leistungsdichtespektrum von Störstrahlung,
- Figur 4: eine durch mehrere Masseleiter von in der Schaltung vorgesehenen Streifenleitungen gebildete Abschirmungsmatrix, und
- Figur 5: eine Ausführungsform der erfindungsgemäßen Schaltung mit einer Abschirmungsmatrix gemäß Figur 4.

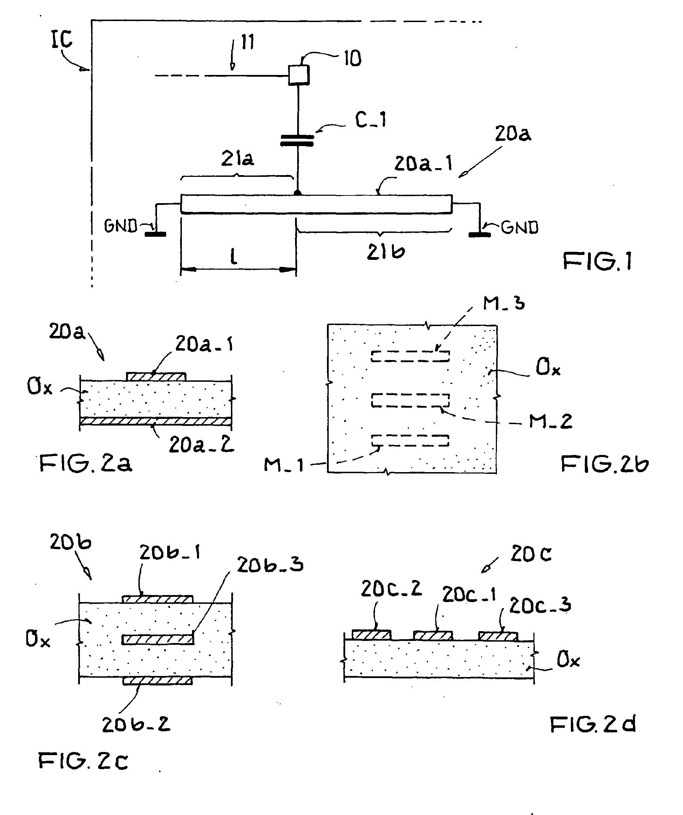

Figur 1 zeigt einen Teil einer monolithisch in eine erfindungsgemäße integrierte Schaltung IC integrierten Entstörvorrichtung, die eine Streifenleitung 20a aufweist, wobei ein als Bondpad 10 ausgebildeter Signalanschluss der Schaltung über einen Koppelkondensator C_1 mit dem Anfang eines ersten Abschnitts 21 a der Streifenleitung 20a verbunden ist. An dem Ende des Abschnitts 21a ist die Streifenleitung 20a nach Masse GND kurzgeschlossen. Eine mit dem Bondpad 10 verbundene Signalleitung ist in Figur 1 durch die Linie 11 angedeutet.

Insgesamt weist die Streifenleitung 20a den bereits in Figur 1 dargestellten Signalleiter 20a_1 sowie einen nicht in Figur 1 abgebildeten zugehörigen Masseleiter 20a_2 auf, der aus dem in Figur 2a gezeigten Querschnitt der Streifenleitung 20a ersichtlich ist. Zwischen den Leitern 20a_1, 20a_2 der Streifenleitung 20a befindet sich als Dielektrikum eine Oxidschicht Ox, die ein Bestandteil der monolithisch integrierten Schaltung ist.

Die Länge 1 des Abschnitts 21a der Streifenleitung 20a (Figur 1) ist erfindungsgemäß so gewählt, dass der Kurzschluss nach Masse GND von dem Ende des Abschnitts 21 a durch den Abschnitt 21a der Streifenleitung 20a in einen Kurzschluss an dem Anfang des Abschnitts 21a transformiert wird, der über den Koppelkondensator C_1 mit dem Bondpad 10 der Schaltung verbunden ist. D.h., die erfindungsgemäße Streifenleitung 20a wird als λ/2-Transformator eingesetzt, 1= λ/2.

Die Frequenz bzw. Wellenlänge λ, für die die Streifenleitung 20a als λ/2-Transformator arbeiten soll, wird in Abhängigkeit eines Störsignals gewählt, das an dem Bondpad 10 z.B. in Form einer leitungsgebundenen Störung oder auch aufgrund einer Störeinstrahlung anliegt, und das durch die erfindungsgemäße Entstörvorrichtung vermindert bzw. unterdrückt werden soll. Aufgrund der verhältnismäßig schmalbandigen Wirkung des durch die Streifenleitung 20a gebildeten λ/2-Transformators ist eine gezielte Störunterdrückung für eine bestimmte Frequenz bzw. Wellenlänge möglich.

Die Wirkung der erfindungsgemäßen Entstörvorrichtung ist nachfolgend unter Bezug auf Figur 3 beispielhaft beschrieben. Figur 3 zeigt ein im Bereich des Bondpads 10 (Figur 1) gemessenes Leistungsdichtespektrum, bei dem eine Leistungsdichte S über der Frequenz f aufgetragen ist. Die mit S_1 bezeichnete Kurve gibt hierbei das Leistungsdichtespektrum für denjenigen Fall an, in dem keine erfindungsgemäße Entstörvorrichtung in der Schaltung vorgesehen ist. Wie aus Figur 3 ersichtlich, überschreitet die Leistungsdichte S_1 in diesem Fall insbesondere in einem Frequenzbereich um die Frequenz f_0 einen zulässigen maximalen Wert S_0. Im Gegensatz hierzu ergibt sich bei der Verwendung der erfindungsgemäßen Entstörvorrichtung und einer entsprechenden Auslegung der Streifenleitung 20a als λ/2-Transformator für die Frequenz f_0 der in Figur 3 durch die gestrichelte Kurve S_2 angedeutete Verlauf des Leistungsdichtespektrums. Der Einsatz der erfindungsgemäßen Entstörvorrichtung, die in Form der beschriebenen Streifenleitung 20a monolithisch in die integrierte Schaltung integriert wird, ermöglicht demzufolge eine effiziente Unterdrückung beziehungsweise Verminderung von Störstrahlung im Bereich des Bondpads 10.

Neben leitungsgebundenen Störungen, die über den Koppelkondensator C_1 (Figur 1) direkt zu der Streifenleitung 20a abgeführt werden, können durch die erfindungsgemäße Entstörvorrichtung auch auf das Bondpad 10 beziehungsweise dessen ggf. vorhandene elektrische Zuleitungen 11 wie beispielsweise Bonddrähte und dergleichen einwirkende Störstrahlungskomponenten vermindert beziehungsweise unterdrückt werden. Mit der erfindungsgemäßen Entstörvorrichtung sind sowohl von außen in die Schaltung eingestrahlte Störstrahlungskomponenten sowie beispielsweise von in der Schaltung vorgesehenen aktiven Komponenten ausgehende Störstrahlung unterdrückbar.

Bei der in Figur 1 abgebildeten Streifenleitung 20a ist neben dem Abschnitt 21a ein weiterer Abschnitt 21b vorgesehen, der sich von dem Anfang des Abschnitts 21a ausgehend in Figur 1 nach rechts erstreckt und an seinem Ende ebenfalls nach Masse GND kurzgeschlossen ist. Der zweite Abschnitt 21 b der Streifenleitung 20a weist vorzugsweise eine von der Länge 1 des ersten Abschnitts 21 a verschiedene Länge auf, und kann somit als λ/2-Transformator für eine weitere Frequenz von zu unterdrückender Störstrahlung eingesetzt werden.

Für zu unterdrückende Störsignale einer ersten Frequenz f_0 (Figur 3) bilden die Abschnitte 21a, 21b der Streifenleitung 20a eine Parallelschaltung aus einem Kurzschluss, der durch den als λ/2-Transformator für die Frequenz f_0 ausgebildeten ersten Abschnitt 21a realisiert wird, und einer von Null verschiedenen Impedanz, die durch den zweiten Abschnitt 21b realisiert wird, weil der zweite Abschnitt als λ/2-Transformator für eine andere Frequenz ausgebildet ist. Das heißt, die beiden Abschnitte 21a, 21b der Streifenleitung 20a beeinflussen sich gegenseitig ihrer Wirkung als λ/2-Transformator für die jeweilige Frequenz nicht.

Durch die erfindungsgemäße Kombination der Abschnitte 21a, 21b kann die Bandbreite der erfindungsgemäßen Entstörvorrichtung gesteigert werden.

Alternativ hierzu ist es jedoch auch möglich, dass die Streifenleitung 20a lediglich einen der beiden Abschnitte 21 a, 21b aufweist.

Figur 2b zeigt einen Schichtaufbau eines Teils der erfindungsgemäßen Schaltung, bei dem innerhalb einer Oxidschicht Ox insgesamt drei Metallisierungsebenen M_1, M_2, M_3 jeweils übereinander angeordnet sind. Ein bei der Darstellung nach Figur 2b unterhalb der Oxidschicht Ox angeordnetes Substrat, das aktive Komponenten der erfindungsgemäßen Schaltung wie beispielsweise Transistoren, Spannungsregler, Oszillatoren oder dergleichen enthält, ist in Figur 2b nicht abgebildet.

Die in Figur 1 abgebildete Streifenleitung 20a ist gemäß dem vorliegenden Ausführungsbeispiel in den Metallisierungsebenen M_1, M_2 aus Figur 2b und einer dazwischen angeordneten Oxidschicht realisiert. Beispielsweise ist der Masseleiter 20a_2 (Figur 2a) der Streifenleitung 20a in der ersten Metallisierungsebene M_1 gemäß Figur 2b realisiert, während der Signalleiter 20a_1 (Figur 2a) der Streifenleitung 20a in der zweiten Metallisierungsebene M_2 gemäß Figur 2b angeordnet ist, die in Figur 2b oberhalb der ersten Metallisierungsebene M_1 angedeutet ist.

Eine Verbindung eines Leiters 20a_1, 20a_2 der Streifenleitung 20a zu einem Massepotential und/oder zu dem Koppelkondensator C_1 (Figur 1) oder zu einem sonstigen Anschlusspunkt ist durch nicht abgebildete Durchkontaktierungselemente, Vias, in herkömmlicher Weise realisiert.

Generell können je nach Ausbildung der Streifenleitung 20a verschiedene Metallisierungsebenen M_1, M_2, M_3 der Schaltung verwendet werden, um die jeweiligen Leiter 20a_1, 20a_2 der Streifenleitung 20a zu realisieren, so dass sich bei der erfindungsgemäßen Entstörvorrichtung vielfältige Möglichkeiten ergeben, die Streifenleitung 20a in der Schaltung anzuordnen.

Bei einer als Triplate-Leitung ausgebildeten Streifenleitung 20b, deren Querschnitt zur Veranschaulichung in Figur 2c abgebildet ist, befindet sich der Signalleiter 20b_3 zwischen den beiden Masseleitern 20b_1, 20b_2 und ist auf diese Weise besonders gut von weiteren Teilen der Schaltung abgeschirmt. Der Signalleiter 20b_3 der in Figur 2c gezeigten Triplate-Leitung 20b kann beispielsweise in der zweiten Metallisierungsebene M_2 der Schaltung, vgl. Figur 2b, angeordnet sein, während die Masseleiter 20b_1, 20b_2 in der ersten und dritten Metallisierungsebene M_1, M_3 der Schaltung realisiert sind.

Bei einer als Koplanarleitung ausgebildeten Streifenleitung 20c nach Figur 2d befindet sich sowohl der Signalleiter 20c_1 als auch die beiden den Signalleiter umgebenden Masseleiter 20c_2, 20c_3 in derselben Metallisierungsebene der Schaltung, bei der es sich beispielsweise um die erste Metallisierungsebene M_1 gemäß Figur 2b handeln kann. Demgemäß ist die Koplanarleitung 20c zur Realisierung der erfindungsgemäßen Entstörvorrichtung besonders zweckmäßig in Schaltungen verwendbar, die nur eine einzige Metallisierungsebene aufweisen.

Generell können bei der erfindungsgemäßen Entstörvorrichtung auch mehrere Streifenleitungen 20a, 20b, 20c vorgesehen und monolithisch in die integrierte Schaltung integriert sein, wobei beispielsweise jeweils eine Streifenleitung 20a, 20b, 20c mit einem vor Störstrahlung zu schützenden Bondpad 10 oder einem sonstigen Anschluss der Schaltung verbunden sein kann. Ferner können auch mehrere, vorzugsweise verschiedene elektrische Längen aufweisende Streifenleitungen 20a, 20b, 20c mit einem Bondpad 10 verbunden sein, so dass diese verschiedenen Streifenleitungen 20a, 20b, 20c jeweils für verschiedene Frequenzen als λ/2-Transformator wirken und gegenüber einer einzigen Streifenleitung eine breitbandigere Störunterdrückung an dem Bondpad 10 ermöglichen.

Bei einer weiteren ganz besonders vorteilhaften Ausführungsform der vorliegenden Erfindung ist ein Wellenwiderstand der Streifenleitung 20a, 20b, 20c so gewählt, dass an dem Anfang des Abschnitts 21 a, 21 b (Figur 1) für eine vorgebbare Frequenz Leistungsanpassung gegeben ist, so dass eine maximale Störleistung von dem Bondpad 10 abgeführt werden kann.

Neben der Möglichkeit, verschiedene Streifenleitungen 20a, 20b, 20c der erfindungsgemäßen Entstörvorrichtung mit unterschiedlichen Längen auszustatten, ist es erfindungsgemäß auch möglich, dass verschiedene Streifenleitungen 20a, 20b, 20c jeweils unterschiedliche Wellenwiderstände aufweisen. Unterschiedliche Wellenwiderstände können beispielsweise über eine Veränderung der Geometrie der Leiter der betreffenden Streifenleitung 20a, 20b, 20c beziehungsweise durch eine entsprechende Auswahl des zwischen den Leitern der Streifenleitung 20a, 20b, 20c angeordneten Dielektrikums erzielt werden.

Anstelle der in Figur 1 abgebildeten kapazitiven Kopplung des Bondpads 10 zu der Streifenleitung 20a mittels des Koppelkondensators C_1 ist es erfindungsgemäß ferner denkbar, das Bondpad 10 direkt an die Streifenleitung 20a anzuschließen, d.h. galvanisch miteinander zu verbinden. Diese Lösung ist insbesondere dann zweckmäßig, wenn ein an dem Bondpad 10 anliegendes Nutzsignal ein hochfrequentes Bandpaßsignal darstellt, für dessen Signalfrequenzen der an dem Ende des Abschnitts 21a (Figur 1) vorhandene Kurzschluss nach Masse GND durch die Streifenleitung 20a bzw. deren Abschnitt 21 a in eine von Null verschiedene Impedanz transformiert wird, wobei der Koppelkondensator C_1 eingespart werden kann.

Vorteilhaft können erfindungsgemäß auch mehrere Signalanschlüsse 10 der Schaltung mit derselben Streifenleitung 20a verbunden werden. Auf diese Weise kann eine Streifenleitung 20a der Entstörvorrichtung gleichzeitig zur Entstörung von zwei oder mehr Signalanschlüssen 10 der Schaltung dienen.

Bei einer weiteren sehr vorteilhaften Ausführungsform der vorliegenden Erfindung sind mehrere Masseleiter 20a_2, 20b_2, 20c_2, 20c_3 verschiedener Streifenleitungen 20a, 20b, 20c gemäß Figur 4 jeweils nebeneinander beziehungsweise orthogonal zueinander angeordnet und mit einem Massepotential GND der Schaltung verbunden und bilden auf diese Weise eine Abschirmungsmatrix AM.

Wie aus Figur 4 ersichtlich, bilden die Masseleiter 20a_2, 20b_2 sowie dazu parallel angeordnete, nicht näher bezeichnete weitere Masseleiter eine Gruppe von in Figur 4 waagerecht angeordneten Masseleitern, die alle mit dem Massepotential GND der Schaltung verbunden sind. Orthogonal hierzu sind die Masseleiter 20c_2, 20c_3 sowie weitere, nicht näher in Figur 4 bezeichnete Masseleiter vorgesehen, die ebenfalls alle mit dem Massepotential GND der Schaltung verbunden sind. Die in Figur 4 waagerecht angeordneten Masseleiter 20a_2, 20b_2 sind beispielsweise in einer ersten Metallisierungsebene M_1 (Figur 2b) der Schaltung realisiert, während die in Figur 4 vertikal dargestellten Masseleiter 20c_2, 20c_3 in der zweiten Metallisierungsebene M_2 (Figur 2b) der Schaltung realisiert sind. Es ist ferner möglich, die Masseleiter 20a_2, 20b_2, 20c_2, 20c_3 untereinander durch entsprechende Durchkontaktierungen zu verbinden.

Die aus den Masseleitern gebildete Abschirmungsmatrix AM bietet einen wirksamen Schutz der erfindungsgemäßen Schaltung vor Störeinstrahlung beziehungsweise Störausstrahlung. Eine frequenzselektive Störunterdrückung durch eine Ausbildung der Streifenleitung 20a als λ/2-Transformator, wie sie vorstehend unter Bezugnahme auf Figur 1 beschrieben ist, wird durch die in Figur 4 gezeigte Konfiguration der Masseleiter nicht beeinträchtigt. Die zu den in Figur 4 abgebildeten Masseleitern 20a_2, 20b_2, 20c_2, 20c_3 gehörenden Signalleiter sind nicht in Figur 4 abgebildet, können aber je nach Ausführungsform der betreffenden Streifenleitung in weiteren Metallisierungsebenen der Schaltung oder auch in derselben Ebene wie der zugehörige Masseleiter angeordnet sein.

Besonders vorteilhaft wird die erfindungsgemäße Abschirmungsmatrix AM gezielt in einem Bereich der Schaltung angeordnet, der vor Störeinstrahlung geschützt werden soll beziehungsweise dessen Störausstrahlung vermindert werden soll. Eine entsprechende Anordnung ist in Figur 5 wiedergegeben, die eine stark vereinfachte Draufsicht auf die erfindungsgemäße integrierte Schaltung IC enthält, die mehrere Komponenten 100, 110, 120 aufweist. Bei der Komponente 120 handelt es sich um einen in die Schaltung IC integrierten Oszillator, der beispielsweise zur Erzeugung eines Referenzsignals für die Schaltung IC vorgesehen ist und der Störstrahlung einer Frequenz f_0 (Figur 3) abstrahlt. Um die von dem Oszillator 120 ausgehende Störstrahlung so abzuschirmen, dass vorgegebene Grenzwerte für die von der Schaltung IC ausgehende Störabstrahlung nicht überschritten werden, ist die erfindungsgemäße Abschirmungsmatrix AM so innerhalb der Schaltung IC angeordnet, dass sie zumindest teilweise den Oszillator 120 abdeckt.

Besonders vorteilhaft ist ein Abstand der Masseleiter 20a_2, 20b_2, 20c_2, 20c_3 (Figur 4) untereinander in Abhängigkeit der Frequenz f_0 der abzuschirmenden Störstrahlung gewählt. Bei einem hinreichend kleinen Abstand, der beispielsweise etwa einem Achtel der Wellenlänge der zu unterdrückenden Störstrahlung entspricht, stellt sich durch die erfindungsgemäße Abschirmungsmatrix AM eine zumindest partielle Abschirmung der Schaltung IC nach dem Faraday-Prinzip ein, die im Vergleich zu der Störunterdrückung mittels einer als λ/2-Transformator ausgebildeten Streifenleitung 20a verhältnismäßig breitbandig ist.

Neben einer Abschirmung von Störstrahlung, die von dem Oszillator 120 ausgeht, wird durch die erfindungsgemäße Abschirmungsmatrix AM auch eine Abschirmung von auf den Oszillator 120 einwirkender Störstrahlung erzielt.

Demgemäß kann die erfindungsgemäße Abschirmungsmatrix AM auch über weiteren Komponenten 100, 110 der Schaltung IC angeordnet sein, um diese vor Störstrahlung von externen Bauteilen oder sonstigen Störern oder dergleichen zu schützen.

Neben der Abschirmung nach dem Faraday-Prinzip ist weiterhin die frequenzselektive Störunterdrückung gemäß der Figur 1 durch die einzelnen Streifenleitungen der Abschirmungsmatrix AM gegeben.

Bei einer weiteren Ausführungsform der vorliegenden Erfindung sind alle Leiter der Streifenleitung 20a miteinander und/oder mit einem Massepotential GND insbesondere direkt im Bereich eines ersten Bondpads 10 (Figur 1) verbunden, wobei das erste Bondpad 10 vorzugsweise über einen Koppelkondensator C_1 mit der Streifenleitung 20a bzw. mit dem Massepotential GND verbunden ist. D.h., im Gegensatz zu der in Figur 1 abgebildeten Ausführungsform ist der Anfang des Abschnitts 21 a direkt im Bereich des Koppelkondensators C_1 nach Masse GND kurzgeschlossen, und eine z.B. um eine halbe Wellenlänge der zu unterdrückenden Störstrahlung entfernte Stelle des Abschnitts 21 a kann beispielsweise mit einem weiteren Bondpad (nicht gezeigt), vorzugsweise ebenfalls über einen Koppelkondensator, verbunden sein und von diesem weiteren Bondpad Störungen in der vorstehend beschriebenen Weise abführen.

## Patentansprüche

1. Monolithisch integrierte Schaltung (IC) mit mindestens einem ein Signal führenden Signalanschluss (10) und mit einer in die Schaltung (IC) integrierten Entstörvorrichtung zur Verringerung von Störstrahlung, **dadurch gekennzeichnet, dass** die Entstörvorrichtung mindestens eine Streifenleitung (20a, 20b, 20c) mit einem Abschnitt (21 a) aufweist, dessen Anfang mit dem Signalanschluss (10) gekoppelt ist, und dessen Ende kurzgeschlossen ist, wobei eine Länge (1) des Abschnitts (21 a) in Abhängigkeit einer vorgebbaren Frequenz, insbesondere in Abhängigkeit einer zu unterdrückenden Frequenz der Störstrahlung, gewählt ist.

2. Schaltung (IC) nach Anspruch 1, **dadurch gekennzeichnet, dass** die Länge (1) des Abschnitts (21a) ein ganzzahliges Vielfaches einer der vorgebbaren Frequenz entsprechenden halben Wellenlänge ist.

3. Schaltung (IC) nach einem der vorstehenden Ansprüche, **dadurch gekennzeichnet, dass** ein Wellenwiderstand der Streifenleitung (20a, 20b, 20c) so gewählt ist, dass an dem Anfang des Abschnitts (21 a) für eine vorgebbare Frequenz Leistungsanpassung gegeben ist.

4. Schaltung (IC) nach einem der vorstehenden Ansprüche, **dadurch gekennzeichnet, dass** ein erster Leiter (20a_1) der Streifenleitung (20a, 20b, 20c) in einer ersten Metallisierungsebene (M_1) der Schaltung (IC) angeordnet ist, und dass ein zweiter Leiter (20a_2) derselben Streifenleitung (20a, 20b, 20c) in einer zweiten Metallisierungsebene (M_2) der Schaltung (IC) angeordnet ist.

5. Schaltung (IC) nach einem der vorstehenden Ansprüche, **dadurch gekennzeichnet, dass** die Streifenleitung (20a, 20b, 20c) als Koplanarleitung ausgebildet ist, bei der alle Leiter der Streifenleitung (20a, 20b, 20c) in einer einzigen Metallisierungsebene (M_1) der Schaltung (IC) angeordnet sind.

6. Schaltung (IC) nach einem der vorstehenden Ansprüche, **dadurch gekennzeichnet, dass** die Streifenleitung (20a, 20b, 20c) als eine drei Leiter (20b_1, 20b_2, 20b_3) umfassende Triplate-Leitung ausgebildet ist, bei der ein erster Masseleiter (20b_1) und ein zweiter Masseleiter (20b_2) der Triplate-Leitung jeweils in verschiedenen Metallisierungsebenen (M_1, M_3) angeordnet ist, und bei der ein Signalleiter (20b_3) der Triplate-Leitung zwischen den die Masseleiter (20b_1, 20b_2) aufnehmenden Metallisierungsebenen (M_1, M_3), vorzugsweise in einer weiteren Metallisierungsebene (M_2), angeordnet ist.

7. Schaltung (IC) nach einem der vorstehenden Ansprüche, **dadurch gekennzeichnet, dass** mehrere Streifenleitungen (20a, 20b, 20c) vorgesehen sind.

8. Schaltung (IC) nach Anspruch 7, **dadurch gekennzeichnet, dass** die mehreren Streifenleitungen (20a, 20b, 20c) vorzugsweise jeweils voneinander verschiedene Längen und/oder Wellenwiderstände aufweisen.

9. Schaltung (IC) nach einem der Ansprüche 7 bis 8, **dadurch gekennzeichnet, dass** zwischen den Leitern verschiedener Streifenleitungen (20a, 20b, 20c) jeweils ein Dielektrikum mit unterschiedlicher Dielektrizitätskonstante vorgesehen ist.

10. Schaltung (IC) nach einem der vorstehenden Ansprüche, **dadurch gekennzeichnet, dass** die Streifenleitung (20a, 20b, 20c) über Mittel zur kapazitiven Kopplung (C_1) mit dem Signalanschluss (10) verbunden ist.

11. Schaltung (IC) nach Anspruch 10, **dadurch gekennzeichnet, dass** mehrere Signalanschlüsse (10) mit derselben Streifenleitung (20a, 20b, 20c) verbunden sind.

12. Schaltung (IC) nach einem der Ansprüche 7 bis 11, **dadurch gekennzeichnet, dass** die Masseleiter (20a_2, 20b_2, 20c_2, 20c_3) verschiedener Streifenleitungen (20a, 20b, 20c) nebeneinander, insbesondere parallel zueinander, und/oder orthogonal zueinander angeordnet und mit einem Massepotential der Schaltung (IC) verbunden sind, um eine Abschirmungsmatrix (AM) zu bilden.

13. Schaltung (IC) nach Anspruch 12, **dadurch gekennzeichnet, dass** die Abschirmungsmatrix (AM) eine Komponente (120) der Schaltung (IC) zumindest teilweise abdeckt, um auf die Komponente (120) einwirkende Störstrahlung und/oder von der Komponente (120) ausgehende Störstrahlung abzuschirmen.

14. Schaltung (IC) nach einem der Ansprüche 12 bis 13, **dadurch gekennzeichnet, dass** ein Abstand der Masseleiter (20a_2, 20b_2, 20c_2, 20c_3) der Abschirmungsmatrix (AM) untereinander in Abhängigkeit mindestens einer Frequenz der abzuschirmenden Störstrahlung gewählt ist.

15. Schaltung (IC) nach einem der Ansprüche 12 bis 14, **dadurch gekennzeichnet, dass** mehrere Masseleiter (20a_2, 20b_2, 20c_2, 20c_3) der Abschirmungsmatrix (AM) in derselben Metallisierungsebene (M_1, M_2, M_3) angeordnet sind und/oder untereinander verbunden sind.

16. Schaltung (IC) nach einem der Ansprüche 10 bis 15, **dadurch gekennzeichnet, dass** alle Leiter (20a_1, 20a_2) der Streifenleitung (20a) miteinander und/oder mit einem Massepotential verbunden sind, insbesondere direkt im Bereich des Signalanschlusses (10).

17. Schaltung (IC) nach einem der vorstehenden Ansprüche, **dadurch gekennzeichnet, dass** der Signalanschluss (10) ein Bondpad der Schaltung (IC) ist.

## Claims

1. Monolithic integrated circuit (IC) with at least one signal connection (10) conducting a signal and with an interference elimination device, which is integrated in the circuit (IC), for reducing interference radiation, **characterised in that** the interference elimination device comprises at least one stripline (20a, 20b, 20c) with a section (21a), the start of which is connected with the signal connection (10) and the end of which is short-circuited, wherein a length (I) of the section (21 a) is selected in dependence on a predeterminable frequency, particularly in dependence on a frequency, which is to be suppressed, of the interference radiation.

2. Circuit (IC) according to claim 1, **characterised in that** the length (I) of the section (21a) is an integral multiple of a half wavelength corresponding with the predeterminable frequency.

3. Circuit (IC) according to one of the preceding claims, **characterised in that** a wave resistance of the stripline (20a, 20b, 20c) is so selected that power adaptation for a predeterminable frequency is given at the start of the section (21 a).

4. Circuit (IC) according to one of the preceding claims, **characterised in that** a first line (20a_1) of the stripline (20a, 20b, 20c) is arranged in a first metallisation plane (M_1) of the circuit (IC) and that a second line (20a_2) of the same stripline (20a, 20b, 20c) is arranged in a second metallisation plane (M_2) of the circuit (IC).

5. Circuit (IC) according to one of the preceding claims, **characterised in that** the stripline (20a, 20b, 20c) is constructed as a coplanar line, in which all lines of the stripline (20a, 20b, 20c) are arranged in a single metallisation plane (M_1) of the circuit (IC).

6. Circuit (IC) according to one of the preceding claims, **characterised in that** the stripline (20a, 20b, 20c) is constructed as a triplate line comprising three lines (20b_1, 20b_2, 20b_3), in which a first earth line (20b_1) and a second earth line (20b_2) of the triplate line are respectively arranged in different metallisation planes (M_1, M_3) and in which a signal line (20b_3) of the triplate line is arranged between the metallisation planes (M_1, M_3) receiving the earth lines (20b_1, 20b_2), preferably in a further metallisation plane (M_2).

7. Circuit (IC) according to one of the preceding claims, **characterised in that** several striplines (20a, 20b, 20c) are provided.

8. Circuit (IC) according to claim 7, **characterised in that** the several striplines (20a, 20b, 20c) preferably have mutually different lengths and/or wave resistances.

9. Circuit (IC) according to one of claims 7 and 8, **characterised in that** dielectrics with different permittivity constants are respectively provided between the conductors of different striplines (20a, 20b, 20c).

10. Circuit (IC) according to one of the preceding claims, **characterised in that** the stripline (20a, 20b, 20c) is connected with the signal connection (10) by way of means for capacitive coupling (C_1).

11. Circuit (IC) according to claim 10, **characterised in that** several signal connections (10) are connected with the same stripline (20a, 20b, 20c).

12. Circuit (IC) according to one of claims 7 to 11, **characterised in that** the earth lines (20a_2, 20b_2, 20c_2, 20c_3) of different striplines (20a, 20b, 20c) are arranged adjacent to one another, particularly parallel to one another, and/or orthogonally to one another and are connected with a ground potential of the circuit (IC) in order to form a screening matrix (AM).

13. Circuit (IC) according to claim 12, **characterised in that** the screening matrix (AM) at least partly covers a component (120) of the circuit (IC) in order to screen interference radiation acting on the component (120) and/or interference radiation emanating from the component (120).

14. Circuit (IC) according to one of claims 12 and 13, **characterised in that** a spacing of the earth lines (20a_2, 20b_2, 20c_2, 20c_3) of the screening matrix (AM) from one another is selected in dependence on at least one frequency of the interference radiation to be screened.

15. Circuit (IC) according to one of claims 12 to 14, **characterised in that** several earth lines (20a_2, 20b_2, 20c_2, 20c_3) of the screening matrix (AM) are arranged in the same metallisation plane (M_1, M_2, M_3) and/or are interconnected.

16. Circuit (IC) according to one of claims 10 to 15, **characterised in that** all lines (20a_1, 20a_2) of the stripline (20a) are connected with one another and/or with a ground potential, in particular directly in the region of the signal connection (10).

17. Circuit (IC) according to one of the preceding claims, **characterised in that** the signal connection (10) is a bond pad of the circuit (IC).

## Revendications

1. Circuit intégré monolithique (IC) comportant au moins une borne de signal (10) conduisant un signal et un dispositif antiparasite intégré dans le circuit (IC) pour réduire le rayonnement parasite, **caractérisé en ce que** le dispositif antiparasite présente au moins une ligne conductrice en bande (20a, 20b, 20c) présentant un tronçon (21a) dont le début est couplé à la borne de signal (10) et dont l'extrémité est court-circuitée, une longueur (1) du tronçon (21a) étant choisie en fonction d'une fréquence pouvant être prédéfinie, plus particulièrement en fonction d'une fréquence du rayonnement parasite à supprimer.

2. Circuit (IC) selon la revendication 1, **caractérisé en ce que** la longueur (1) du tronçon (21a) est un multiple entier d'une demi longueur d'onde correspondant à la fréquence pouvant être prédéfinie.

3. Circuit (IC) selon l'une quelconque des revendications précédentes, **caractérisé en ce qu'**une impédance caractéristique d'une ligne en bande (20a, 20b, 20c) est choisie de telle manière qu'au début du tronçon (21a) existe une adaptation d'énergie pour une fréquence pouvant être prédéfinie.

4. Circuit (IC) selon l'une quelconque des revendications précédentes, **caractérisé en ce qu'**un premier conducteur (20a_1) de la ligne en bande (20a, 20b, 20c) est disposé dans un premier plan de métallisation (M_1) du circuit (IC), et **en ce qu'**un deuxième conducteur (20a_2) de la même ligne en bande (20a, 20b, 20c) est disposé dans un deuxième plan de métallisation (M_2) du circuit (IC).

5. Circuit (IC) selon l'une quelconque des revendications précédentes, **caractérisé en ce que** la ligne en bande (20a, 20b, 20c) est réalisée sous la forme d'une ligne coplanaire, dans laquelle tous les conducteurs de la ligne en bande (20a, 20b, 20c) sont disposées dans un unique plan de métallisation (M_1) du circuit (IC).

6. Circuit (IC) selon l'une quelconque des revendications précédentes, **caractérisé en ce que** la ligne en bande (20a, 20b, 20c) est réalisée sous la forme d'une ligne triplaque comprenant trois conducteurs (20b_1, 20b_2, 20b_3), dans laquelle un premier conducteur de masse (20b_1) et un deuxième conducteur de masse (20b_2) de la ligne triplaque sont disposés chacun dans des plans de métallisation (M_1, M_3) différents, et dans laquelle un conducteur de signal (20b_3) de la ligne triplaque est disposé entre les plans de métallisation (M_1, M_3) recevant les conducteurs de masse (20b_1, 20b_2), de préférence dans un autre plan de métallisation (M_2).

7. Circuit (IC) selon l'une quelconque des revendications précédentes, **caractérisé en ce que** l'on prévoit plusieurs lignes en bande (20a, 20b, 20c).

8. Circuit (IC) selon l'une quelconque des revendications précédentes, **caractérisé en ce que** les plusieurs lignes en bande (20a, 20b, 20c) présentent des longueurs et/ou des impédances caractéristiques de préférence à chaque fois différentes les unes des autres.

9. Circuit (IC) selon l'une quelconque des revendications 7 à 8, **caractérisé en ce que** l'on prévoit entre les conducteurs de différentes lignes en bande (20a, 20b, 20c) à chaque fois un diélectrique à constante diélectrique différente.

10. Circuit (IC) selon l'une quelconque des revendications précédentes, **caractérisé en ce que** la lignes en bande (20a, 20b, 20c) est reliée par des moyens de couplage capacitif (C_1) à la borne de signal (10).

11. Circuit (IC) selon la revendication 10, **caractérisé en ce que** plusieurs bornes de signal (10) sont reliées à la même ligne en bande (20a, 20b, 20c).

12. Circuit (IC) selon l'une quelconque des revendications 7 à 11, **caractérisé en ce que** les conducteurs de masse (20a_2, 20b_2, 20c_2, 20c_3) de différentes lignes en bande (20a, 20b, 20c) sont disposés côte à côte, plus particulièrement parallèles l'un à l'autre, et/ou de manière orthogonale l'un par rapport à l'autre et sont reliés à un potentiel de masse du circuit (IC) pour former une matrice de blindage (AM).

13. Circuit (IC) selon la revendication 12, **caractérisé en ce que** la matrice de blindage (AM) recouvre au moins partiellement un composant (120) du circuit (IC) pour blinder contre le rayonnement parasite agissant sur le composant (120) et/ou le rayonnement parasite émis par le composant (120).

14. Circuit (IC) selon l'une quelconque des revendications 12 à 13, **caractérisé en ce qu'**un intervalle séparant les conducteurs de masse (20a_2, 20b_2, 20c_2, 20c_3) de la matrice de blindage (AM) est choisie en fonction d'au moins une fréquence du rayonnement parasite à supprimer.

15. Circuit (IC) selon l'une quelconque des revendications 12 à 14, **caractérisé en ce que** plusieurs conducteurs de masse (20a_2, 20b 2, 20c_2, 20c 3) de la matrice de blindage (AM) sont disposés dans le même plan de métallisation (M_1, M_2, M_3) et/ou sont reliés entre eux.

16. Circuit (IC) selon l'une quelconque des revendications 10 à 15, **caractérisé en ce que** tous les conducteurs (20a_1, 20a_2) de la ligne en bande (20a) sont reliés entre eux et/ou au potentiel de masse, en particulier directement dans la zone de la borne de signal (10).

17. Circuit (IC) selon l'une quelconque des revendications précédentes, **caractérisé en ce que** la borne de signal (10) est une pastille de contact du circuit (IC).
